# FASCICULE DE BREVET EUROPEEN

(11) **EP 2 095 502 B1**
(45) Date de publication et mention de la délivrance du brevet: **03.09.2014**
(21) Numéro de dépôt: 08701480.9
(22) Date de dépôt: 15.01.2008
(51) Int. Cl.: H03F 3/45, G05F 1/56, H03F 1/32

(54) **AMPLIFICATEUR A TRANSCONDUCTANCE A LINEARITE AMELIOREE**
TRANSKONDUKTANZVERSTÄRKER MIT VERBESSERTER LINEARITÄT
TRANSCONDUCTANCE AMPLIFIER WITH IMPROVED LINEARITY

(30) Priorité: 16.01.2007 FR 0700285
(43) Date de publication de la demande: 02.09.2009
(73) Titulaire: Commissariat à l'Énergie Atomique et aux Énergies Alternatives, 75015 Paris (FR)
(72) Inventeur: WEI, James, 8135 Langnau am Albis (CH)
(74) Mandataire: Guérin, Michel
(86) Numéro de dépôt international: PCT/EP2008/050369
(87) Numéro de publication internationale: WO 2008/090051

(56) Documents cités:
- US-A- 3 984 780
- US-A- 4 103 190
- KWAN T ET AL: "An adaptive analog continuous-time CMOS biquadratic filter" PROCEEDINGS OF THE CUSTOM INTEGRATED CIRCUITS CONFERENCE. SAN DIEGO, MAY 12 - 15, 1991, NEW YORK, IEEE, US, vol. CONF. 13, 12 mai 1991 (1991-05-12), pages 93-1, XP010044616 ISBN: 0-7803-0015-7 cité dans la demande
- SEDRA A S ET AL: "THE CURRENT CONVEYOR: HISTORY, PROGRESS AND NEW RESULTS" IEE PROCEEDINGS G. ELECTRONIC CIRCUITS & SYSTEMS, INSTITUTION OF ELECTRICAL ENGINEERS. STEVENAGE, GB, vol. 137, no. 2, PART G, 1 avril 1990 (1990-04-01), pages 78-87, XP000102774 ISSN: 0622-0039

## Description

L'invention concerne un amplificateur à transconductance, destiné à fournir des variations de courant di lorsqu'il reçoit des variations de tension dv, et ceci avec un coefficient de conversion désiré Gm appelé transconductance : Gm=di/dv

L'invention est applicable tout particulièrement pour réaliser certains types d'échantillonneurs-bloqueurs, plus précisément ceux qui fonctionnent en échantillonnant une quantité de charges plutôt qu'une valeur ponctuelle de tension. Par ailleurs, l'invention s'applique non seulement à des circuits destinés à convertir une variation de tension simple en une variation de courant simple, mais aussi à des circuits différentiels destinés à convertir une variation de tension différentielle en une variation de courant différentielle.

Pour situer le contexte de cette invention, on peut rappeler que l'on préfère quelquefois échantillonner des charges plutôt que des tensions, pour réduire l'influence du bruit d'horloge (parfois aussi appelé "jitter" ou gigue d'horloge) lorsqu'on veut échantillonner un signal à haute fréquence sous le contrôle d'une horloge qui définit les phases d'échantillonnage périodique. En intégrant non pas un niveau de tension dans une capacité d'échantillonnage mais un courant pendant une durée d'échantillonnage connue, on réduit l'influence de ce bruit d'horloge. Mais alors, comme le signal d'entrée à convertir se présente généralement sous forme d'une tension (ou plus exactement de variations de tension à haute fréquence), il faut placer en amont de la ou les capacités d'échantillonnage un amplificateur à transconductance de grande qualité qui va convertir avec précision les variations de tension en variations de courant. L'échantillonnage en courant est par ailleurs utile si on veut intégrer des échantillons multiples dans une même capacité.

Les performances qu'on attend d'un tel amplificateur à transconductance sont les suivantes : une valeur de transconductance forte et très bien connue, un comportement linéaire, c'est-à-dire une transconductance indépendante du niveau de signal à convertir, une forte impédance de sortie, un bruit interne aussi faible que possible, une large bande passante.

Certaines de ces performances sont contradictoires. En effet, pour obtenir une large bande passante, en particulier vers les fréquences de signal élevées, il faut réaliser le circuit dans des technologies à très petites longueurs de grille, notamment des technologies dites submicroniques (transistors dont la longueur de canal n'est qu'une fraction de micromètre). Mais des transistors à très courtes longueurs de canal ont une transconductance propre drain-source g_{ds} qui n'est pas nulle comme ce serait le cas pour un transistor idéal ; la transconductance propre drain-source g_{ds} est le rapport entre le courant de drain (en petits signaux) qui traverse le transistor et la tension (en petits signaux) entre drain et source pour une polarisation donnée du transistor. Si cette transconductance n'est pas nulle, c'est-à-dire si les variations de courant de drain ne sont pas indépendantes des variations de tension entre drain et source, alors on s'aperçoit qu'on obtient difficilement un amplificateur à transconductance de valeur suffisamment élevée et suffisamment linéaire, à impédance de sortie très élevée, et à bas bruit ; le bruit en 1/f notamment augmente beaucoup.

Par conséquent, on est obligé de choisir entre une large bande passante, obtenue par miniaturisation de la technologie, et les autres qualités de l'amplificateur à transconductance.

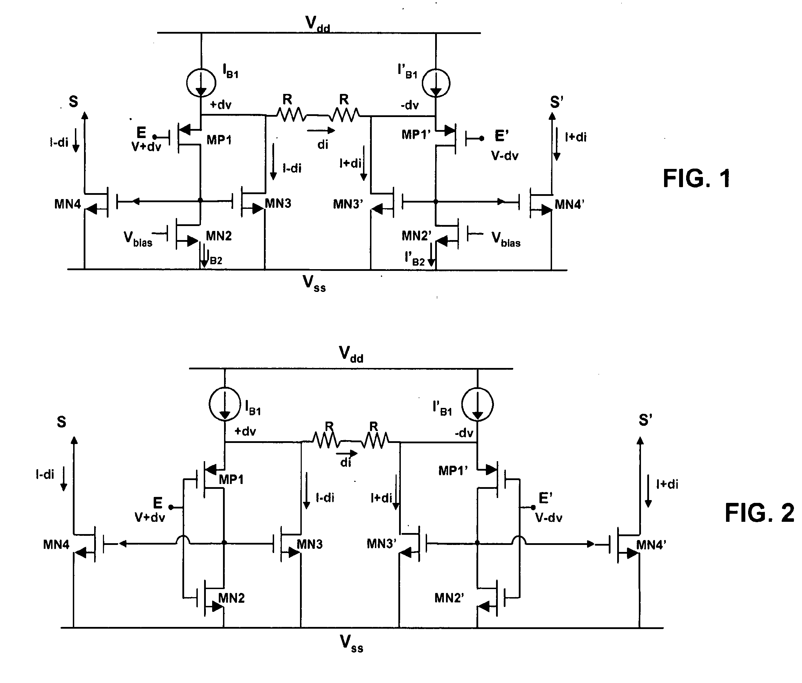

La figure 1 représente un exemple d'amplificateur à transconductance de technologie MOS proposé dans l'art antérieur par T. Kwan et K. Martin "An Adaptative Analog Continuous-time CMOS biquadratic filter " dans IEEE Journal of Solid State Circuits Vol. 26 pp 859-867, Juin 1991.

L'amplificateur à transconductance de la figure 1 est un amplificateur différentiel ayant deux entrées E, E' entre lesquelles est appliquée une tension différentielle d'entrée (en petits signaux à haute fréquence) V+dv, V-dv, à convertir en courant différentiel I-di, I+di sur deux sorties différentielles en courant S et S'. V est une tension de mode commun sur les entrées, I est un courant de polarisation identique sur les deux sorties.

L'amplificateur est symétrique puisqu'on travaille ici en différentiel et comporte donc deux moitiés identiques. La première moitié comprend un ensemble en série d'un premier et un deuxième transistors MOS (MP1, MN2) de type opposé reliés par leurs drains ; la grille du premier transistor MP1 est reliée à l'entrée E ; la source est reliée à une source de courant constant I_{B1} ainsi qu'à une résistance de valeur R et au drain d'un troisième transistor MOS MN3 de même type que le deuxième ; la source du deuxième transistor MN2 et celle du troisième transistor MN3 sont à la masse (Vss) ; la grille du transistor MN3 est reliée aux drains des premier et deuxième transistors ; et l'amplificateur comporte en outre un quatrième transistor MN4 dont la fonction est de recopier vers la sortie S le courant qui parcourt le transistor MN3 ; les sources des deuxième et quatrième transistors, MN2 et MN4 sont donc reliées, leurs grilles aussi. Enfin, la grille du transistor MN2 est polarisée par une tension fixe V_{bias} pour que ce transistor agisse en source de courant et maintienne une valeur de courant constante, de valeur I_{B2}, dans les transistors MP1 et MN2. L'autre moitié de l'amplificateur est constituée par un ensemble identique de quatre transistors, désignés par les mêmes références affectées du signe 'prime', et raccordés de la même manière entre l'entrée E' et la sortie S' ; les sources de courant sont identiques dans les deux moitiés d'amplificateur, les résistances aussi ainsi que les constitutions de transistors. Les résistances de valeur R sont reliées ensemble et constituent une seule résistance de valeur 2R partagée entre les deux moitiés de l'amplificateur ; cette résistance de valeur 2R relie en effet les drains des troisièmes transistors MN3, MN3' des deux ensembles.

Ce schéma fonctionne idéalement de la manière suivante : le transistor MP1 parcouru par un courant constant est un suiveur de tension ; les petites variations dv sur sa grille se répercutent intégralement sur sa source. Il en est de même de MP1', avec une variation opposée (-dv). La résistance de valeur 2R voit une variation de tension 2dv a ses bornes. Elle est parcourue par une variation de courant di = 2dv/2R = dv/R qui ne peut circuler ni dans la branche I_{B1} ni dans les transistors MP1, MN2, MP1', MN2' dont les courants sont fixés à I_{B2}. La variation de courant dV/R ne peut circuler que dans les transistors MN3 (dans un sens) et MN3' (dans l'autre sens). Il circule en pratique dans le transistor MN3 un courant I-di et dans le transistor MN3' un courant I+di, où le courant de polarisation commun I est simplement I_{B1}-I_{B2}.

Les courants I-di et I+di sont recopiés par les transistors MN4 et MN4' pour constituer les courants différentiels de sortie I-di = I-dv/R dans un sens sur S, et I+di = I+dv/R dans l'autre sens sur S'. L'amplificateur a donc une transconductance di/dv égale à 1/R pour les petits signaux ; cette transconductance est bien maîtrisée et très linéaire. On fait l'hypothèse simplificatrice que la recopie de courant est faite avec un facteur 1. On comprendra que ce facteur pourrait être différent en choisissant un rapport de géométries différent de 1 entre les transistors MN3 et MN4.

Mais ceci suppose des transistors et une source de courant I_{B1} (également constituée en pratique par un transistor) ayant des caractéristiques idéales et en particulier une transconductance propre drain-source g_{ds} nulle. Lorsqu'elle n'est pas nulle, on aboutit à une situation dans laquelle les transistors MP1 et MP1' n'agissent pas en véritables suiveurs de tension et le courant de sortie différentiel di dépend alors du niveau du signal d'entrée dv ; ceci est difficilement acceptable, notamment dans les applications d'échantillonnage blocage, surtout si l'échantillonnage est fait en vue d'une conversion analogique-numérique précise. De plus, avec des transistors non idéaux, tout particulièrement en technologie sub-micronique (longueurs de grille inférieures à 1 micromètre), les impédances de sortie se réduisent, et les capacités parasites commencent à réduire la bande passante.

Pour améliorer le compromis entre les différentes qualités de l'amplificateur à transconductance, on propose selon l'invention de modifier le principe d'amplificateur qui vient d'être décrit, pour rendre la valeur de transconductance notablement plus indépendante du niveau de signal, même lorsque les transistors qui composent le circuit ont une transconductance propre g_{ds} non négligeable. On rend ainsi la réalisation d'un bon amplificateur à transconductance compatible avec les technologies sub-microniques qui par ailleurs permettent de travailler à plus haute fréquence.

On notera que l'amplificateur modifié selon l'invention pourrait aussi être réalisé avec des transistors bipolaires, et par conséquent, dans tout ce qui suit on considérera que l'appellation "transistor" recouvre à la fois les transistors MOS et les transistors bipolaires et que les appellations "source", "drain", et "grille", classiquement utilisées pour les transistors MOS, doivent être interprétées comme signifiant respectivement "émetteur", "collecteur" et "base", si les transistors sont bipolaires. Des transistors MOS de type opposé sont alors des transistors NMOS et PMOS, des transistors bipolaires de type opposé sont des transistors NPN et PNP respectivement.

Plus précisément, on propose selon l'invention de relier non seulement la grille du premier transistor MP1 mais aussi la grille du deuxième transistor MN2 à l'entrée de signal à convertir E. Ceci est valable aussi bien en différentiel (dans lequel la résistance R est reliée entre les drains des deux transistors MN3 et MN3') que dans le cas d'un amplificateur simple, non-différentiel (dans lequel la résistance R serait reliée à un potentiel fixe).

Par conséquent, l'invention propose un amplificateur à transconductance pour la conversion de petites variations de tension électrique dv en variations de courant électrique di, comportant un ensemble en série d'un premier et un deuxième transistors de type opposé reliés par leurs drains, la grille du premier transistor étant reliée à une entrée de signal de tension à convertir en courant, la source du premier transistor étant reliée à une source de courant constant ainsi qu'à une résistance et au drain d'un troisième transistor de même type que le premier, les sources du deuxième et troisième transistors étant réunies, la grille du troisième transistor étant reliée aux drains des premier et deuxième transistors, et l'amplificateur comportant en outre un circuit de recopie du courant du troisième transistor, ce circuit de recopie constituant une sortie de l'amplificateur à transconductance, caractérisé en ce que la grille du deuxième transistor est reliée à la grille du premier transistor.

En appliquant le signal dv aussi bien à la grille du transistor MP1 (tendant à faire varier le courant de drain de MP1 dans un sens) qu'à la grille du transistor MN2 (tendant à faire varier le courant de drain de MN2 dans l'autre sens), on constate qu'on améliore le gain de boucle du transistor suiveur, c'est-à-dire qu'on obtient une meilleure égalité entre les variations de potentiel de grille dv et les variations de potentiel sur le drain du transistor suiveur MP1.

De préférence, on prévoit un circuit de contre-réaction pour commander la valeur de la source de courant dans un sens tendant à maintenir la plus constante possible la tension de mode commun sur les drains des premier et deuxième transistors.

L'amplificateur à transconductance selon l'invention (surtout dans sa version différentielle) est particulièrement utile dans une application à un échantillonneur-bloqueur, par exemple un échantillonneur-bloqueur d'entrée d'un convertisseur analogique numérique très rapide. Il sert alors à charger, pendant une phase d'échantillonnage périodique de durée constante, au moins une capacité d'échantillonnage.

L'invention est applicable aussi à la réalisation de filtres échantillonnés à réponse impulsionnelle finie, notamment en télécommunications pour filtrer et changer de fréquence la fréquence d'un signal radiofréquence.

D'autres caractéristiques et avantages de l'invention apparaîtront à la lecture de la description détaillée qui suit et qui est faite en référence aux dessins annexés dans lesquels :
- la figure 1, déjà décrite, représente un amplificateur à transconductance de l'art antérieur ;
- la figure 2 représente un amplificateur à transconductance différentiel selon l'invention ;
- la figure 3 représente un amplificateur à transconductance non différentiel ;
- la figure 4 représente un perfectionnement de l'amplificateur de la figure 2 ;
- la figure 5 représente un étage de sortie possible pour l'amplificateur à transconductance ;
- la figure 6 représente une application de l'amplificateur à transconductance comme circuit d'entrée d'un échantillonneur-bloqueur ;
- la figure 7 représente le chronogramme de fonctionnement du circuit de la figure 6.

La figure 2 sera décrite par référence à la figure 1 déjà décrite en détail. En effet, les éléments de circuit sont les mêmes et seule la connexion de grille du transistor MN2, et bien sûr aussi du transistor MN'2, est différente.

La grille du deuxième transistor MN2 n'est pas reliée à une tension de polarisation constante tendant à faire de ce transistor une simple source de courant constant, mais elle est reliée à la grille du premier transistor MP1, c'est-à-dire qu'elle est reliée à l'entrée E qui reçoit la tension V+dv à convertir en courant. De même la grille du transistor MN2' est maintenant reliée à la grille du transistor MP1'.

Bien que cette configuration tende à augmenter la capacité parasite d'entrée, puisqu'on a maintenant deux grilles de transistors connectées à l'entrée, on a constaté que le montage améliore la linéarité, parce qu'il réduit l'influence de la valeur des transconductances propres drain-source du transistor MP1 et de la source de courant I_{B1}.

Dans le schéma de la figure 1, le transistor MP1 parcouru par un courant constant est un suiveur de tension mais sa transconductance propre drain-source (variation de courant drain avec la tension drain-source en petits signaux) fait que la tension sur sa source ne suit pas exactement la tension sur sa grille. Le petit écart qui est produit tend à se répercuter sur le courant qui parcourt les résistances de valeur R donc sur la valeur de la transconductance de l'amplificateur. Celle-ci se met à dépendre de l'amplitude du signal d'entrée dv. Cependant, la variation de tension dv appliquée à l'entrée agit non seulement sur le transistor MP1 mais aussi sur le transistor MN2 ; et elle agit dans un sens contraire, c'est-à-dire qu'elle tend à compenser l'effet qui est produit du fait de la transconductance non nulle du transistor MP1. Au total, si on admet que les transconductances de MP1 et MN2 sont sensiblement identiques en valeur absolue, on constate que le transistor MP1 agit à nouveau comme un excellent suiveur, sa tension de source suivant très étroitement la tension de grille indépendamment de l'amplitude du signal d'entrée dv.

Les petites variations dv sur l'entrée se répercutent donc intégralement sur la résistance de valeur R reliée au drain de MP1. Il en est de même pour le transistor MP1', avec une variation opposée (-dv). La résistance globale de valeur 2R voit une variation de tension 2dv a ses bornes. Elle est parcourue par une variation de courant 2dv/2R qui va circuler dans les transistors MN3 (dans un sens) et MN3' (dans l'autre sens).

Cette variation de courant, ainsi que le courant de polarisation commun I = I_{B1}-I_{B2} est recopiée par les transistors MN4 et MN4' pour constituer les courants différentiels de sortie I-di = I-dv/R dans un sens sur S, et I+di=I+dv/R dans l'autre sens sur S'. L'amplificateur a donc une transconductance di/dv égale à 1/R pour les petits signaux ; cette transconductance est bien maîtrisée et très linéaire. Là encore, on fait l'hypothèse que la recopie de courant est faite avec un facteur 1 mais on pourrait avoir un facteur différent en choisissant un rapport de géométries différent de 1 entre les transistors MN3 et MN4.

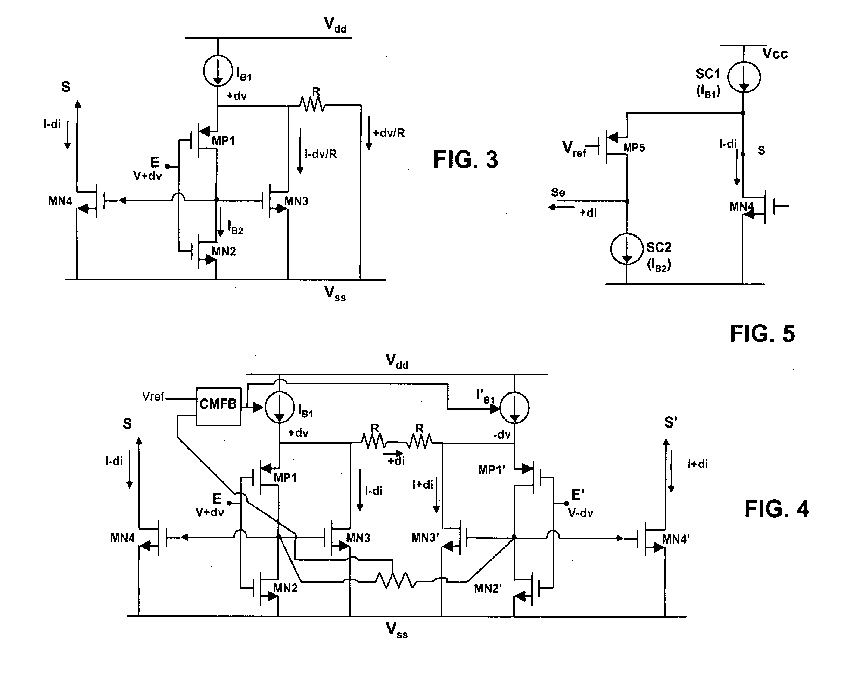

Le schéma de la figure 2 est conçu pour une application différentielle, mais on peut envisager le même schéma avec une tension d'entrée simple (non différentielle) et un courant de sortie simple. La figure 3 représente un tel schéma. On a supprimé une moitié complète de l'amplificateur, en l'occurrence la moitié droite. Le point milieu des résistances de valeur R est maintenant porté à la référence de masse. Les variations de tension dv en petits signaux se reportent sur le drain du transistor MP1, et sont converties par la résistance R en variations de courant dv/R, c'est-à-dire la même valeur que précédemment.

Dans un perfectionnement, on peut prévoir en outre que la source de courant I_{B1} (et bien sûr aussi I'_{B1} dans le schéma différentiel) est asservie par rapport à la tension de mode commun présente sur les drains réunis des transistors MP1 et MN2. En effet, la variation de cette tension de mode commun peut se traduire par une variation du courant constant de la source I_{B1}, tout simplement à cause de la transconductance propre de cette source. C'est pourquoi on préfère asservir le courant de la source par un circuit de contre-réaction CMFB qui reçoit la tension de mode commun sur les drains des transistors MP1 et MN2 et qui établit un signal de commande de la source I_{B1}. L'action du signal de commande va dans un sens qui tend à s'opposer au sens de variation naturelle de la tension en fonction du courant. Un petit circuit de contre-réaction de mode commun CMFB peut donc être prévu, recevant d'une part la tension de mode commun sur ces drains et d'autre part une référence de tension Vref ; le circuit de contre-réaction produit une tension de commande de la source I_{B1} (par exemple une tension de polarisation sur la grille d'un transistor constituant cette source). Si la tension de mode commun s'écarte dans un sens ou dans l'autre de la référence, la variation de courant I_{B1} qui en résulte tend à l'en rapprocher.

La figure 4 représente cette configuration de circuit. Il s'agit d'un montage différentiel mais la même commande est appliquée aux deux sources de courant I_{B1} et I'_{B1} ; la tension de mode commun est alors prélevée sur le point milieu d'un pont diviseur résistif connecté entre les drains réunis de MP1 et MN2 d'une part, MP1' et MN2' d'autre part. Une autre solution est de prélever la tension de mode commun non pas à cet endroit mais, dans le cas d'un échantillonneur-bloqueur, sur les capacités d'échantillonnage (non représentées) qui sont placées en aval des transistors de sortie MN4 et MN'4 et qui intègrent les courants de sortie di et -di. Ces capacités sont alors chargées pendant une phase d'échantillonnage puis réunies pendant une phase de blocage au cours de laquelle elles sont appliquées comme signal d'entrée au circuit CMFB. Le but de ce circuit de régulation est de réguler les courants de polarisation I_{B1}, I'_{B1} de telle sorte que la tension de mode commun sur les capacités d'échantillonnage (à la sortie de l'échantillonneur bloqueur) reste constante quelle que soit la dispersion de technologie ou de fabrication. Cela a pour avantage de garder une valeur maximale pour la dynamique de signal utile, et par conséquent d'éviter des distorsions.

La figure 5 représente un étage de sortie qu'il est possible de connecter en aval du transistor MN4 ou MN'4 qui fournit le courant I-di ou I+di. Cet étage de sortie est destiné à éliminer le courant de polarisation commun I et à fournir uniquement le courant di, en vue par exemple d'un échantillonnage d'une quantité de charges représentative du courant di dans une capacité commutée.

On a vu que le courant I est la différence entre le courant de la source I_{B1} qui alimente l'ensemble des transistors MP1, MN2, MN3 et la résistance 2R et le courant I_{B2} qui parcourt les transistors MP1 et MN2 en l'absence de signal dv.

On utilise un montage dit "cascode replié" avec un transistor MP5, de même type que MP1, c'est-à-dire PMOS. Ce transistor MP5 a sa source reliée au drain du transistor MN4 de l'étage de recopie (donc à la sortie du circuit de recopie) ; l'ensemble de la source de MP5 et du drain de MN4 sont alimentés par une source de courant SC1 de valeur égale à I_{B1}. Le drain de MP5 est alimenté par une source de courant SC2 de valeur égale à I_{B2}.

Dans ces conditions, on voit que le transistor MP5 est nécessairement parcouru par un courant I_{B1}-(I-di), c'est-à-dire I_{B1}-(I_{B1}-I_{B2}-di), ou encore I_{B2}+di. Comme la source de courant SC2 consomme I_{B2}, le courant di s'évacue vers la sortie Se prélevée sur le drain de MP5. Cette sortie Se peut être connectée à travers un système de commutateurs à une capacité d'échantillonnage si l'amplificateur est utilisé dans un échantillonneur-bloqueur.

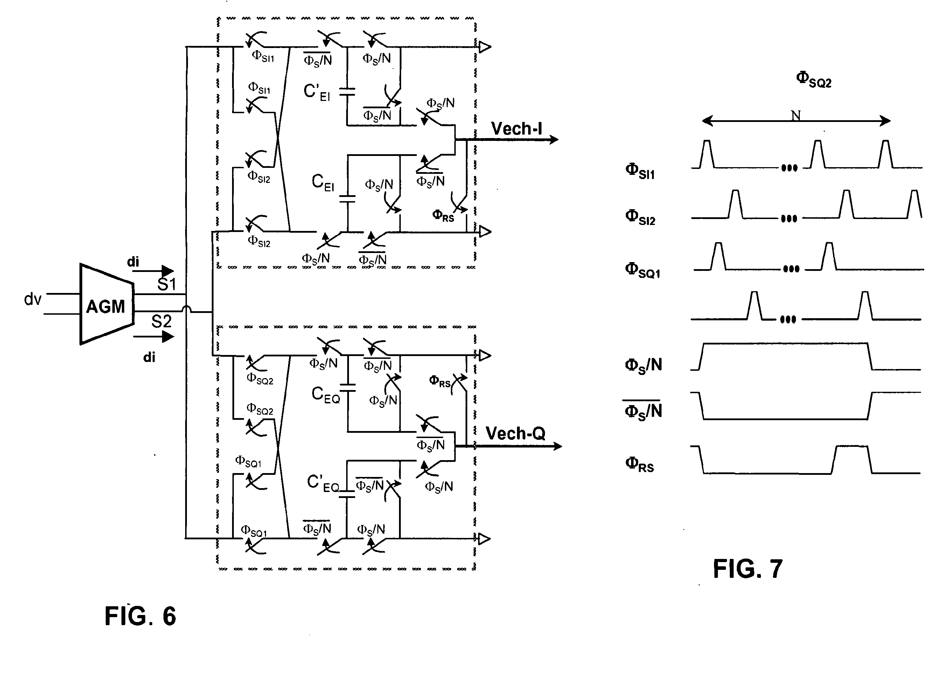

La figure 6 représente l'application de l'amplificateur à transconductance à un circuit d'échantillonnage, destiné notamment à un convertisseur analogique-numérique rapide, le circuit d'échantillonnage effectuant de plus une décimation d'ordre N, c'est-à-dire une production d'échantillons de sortie à une fréquence N fois inférieure à la fréquence d'échantillonnage Fe. Ainsi, le système comporte une horloge d'échantillonnage fournissant des phases d'échantillonnage Φ_{S} à fréquence Fe et une horloge de fréquence inférieure Fe/N fournissant des phases Φ_{S}/N correspondant à la durée de N échantillons successifs.

L'amplificateur est, dans cet exemple, de type différentiel et il est désigné par la référence AGM ; il possède une entrée recevant la tension dv à convertir (seuls les petits signaux et non la tension de mode commun V sont considérés ici). Il possède des sorties S1 et S2 fournissant les courants di et -di. On fait l'hypothèse ici que le courant di est un courant sortant sur S1 et le courant -di est un courant rentrant sur S2, de sorte qu'il sort aussi de S2 un courant +di. On n'a pas représenté les moyens permettant d'obtenir un courant rentrant, mais on sait le faire à partir de miroirs de courant.

Le schéma qui est représenté correspond à une application d'échantillonnage dans laquelle l'échantillonneur délivre alternativement des échantillons I et Q en quadrature de phase, ce qui suppose deux capacités d'échantillonnage séparées. De plus, le schéma correspond à une application dans laquelle, les échantillons sont placés alternativement dans deux capacités différentes, de sorte qu'on stocke un échantillon dans une première capacité pendant que l'échantillon précédent, bloqué, est lu par un circuit aval (un convertisseur analogique-numérique par exemple). C'est pourquoi, au lieu d'une seule capacité d'échantillonnage qui suffirait théoriquement, la figure 6 comporte quatre capacités, C_{EI} et C'_{EI} qui fonctionnent en alternance pour la phase I et C_{EQ} et C'_{EQ} qui fonctionnent en alternance pour la phase en quadrature Q.

En outre, chaque capacité reçoit successivement un échantillon de charges de la sortie différentielle S1 suivi d'un échantillons de charges de la sortie différentielle S2, avec des signes opposés de manière que les échantillons s'additionnent et ne se soustraient pas dans la capacité.

Les capacités C_{EI} et C_{EQ} reçoivent des échantillons pendant les phases Φ_{S}/N de la fréquence de décimation Fe/N. Elles sont lues pendant les phases complémentaires de cette fréquence. La remise à zéro par une phase Φ_{RS} a lieu à la fin de la phase complémentaire. Les capacités désignées par l'indice prime travaillent en alternance avec les premières.

Sur la figure 6, les commutateurs du filtre sont désignés par les phases qui les contrôlent ; ces commutateurs sont de trois sortes :
- ceux qui sont actionnés par des impulsions à la fréquence d'échantillonnage Fe ; l'indice 1 dans le nom de la phase signifie qu'ils appliquent à une capacité la sortie S1 de l'amplificateur à transconductance différentiel ; l'indice I ou Q signifie qu'ils concernent le stockage d'un échantillon I ou Q ;
- ceux qui sont actionnés par la fréquence de décimation Fe/N, les phases étant inversées pour les capacités affectées d'un signe 'prime' ;
- et ceux qui sont actionnés par l'impulsion de remise à zéro Φ_{RS}.

Pendant une phase d'échantillonnage relative aux capacités C_{EI} et C_{EQ} quatre commutations se produisent successivement :
- application d'un échantillon de charges de la sortie S vers la capacité C_{EI} ;
- en quadrature de phase, c'est-à-dire avec un décalage temporel d'un quart de période 1/Fe de l'horloge d'échantillonnage, application d'un échantillon de la sortie S1 à la capacité G_{EQ} ;
- au coup d'horloge suivant, application d'un échantillon de la sortie S2 à la capacité C_{EI} ;
- et enfin, avec un nouveau décalage en quadrature, application d'un échantillon de la sortie S2 à la capacité C_{EQ}.

Le chronogramme des signaux correspondants est représenté sur la figure 7.

La sortie du bloc d'échantillonnage de la voie I fournit un niveau analogique échantillonné Vech-I ; la sortie du bloc d'échantillonnage de la voie Q fournit un niveau analogique échantillonné Vech-Q.

Dans tout ce qui précède, les transistors MOS peuvent être remplacés par des transistors bipolaires comme cela a été indiqué.

## Revendications

1. Amplificateur à transconductance pour la conversion de petites variations de tension électrique dv en variations de courant électrique di, comportant un ensemble en série d'un premier et un deuxième transistors de type opposé reliés par leurs drains, la grille du premier transistor (MP1) étant reliée à une entrée de signal à convertir en courant, la source du premier transistor étant reliée à une source de courant constant (I_{B1}) ainsi qu'à une résistance et au drain d'un troisième transistor de même type que le premier, les sources du deuxième (MN2) et troisième (MN3) transistors étant réunies, la grille du troisième transistor étant reliée aux drains des premier et deuxième transistors, et l'amplificateur comportant en outre un circuit (MN4) de recopie du courant du troisième transistor, **caractérisé en ce que** la grille du deuxième transistor est reliée à la grille du premier transistor.

2. Amplificateur à transconductance selon la revendication 1, **caractérisé en ce qu'**il comporte un circuit de contre-réaction (CMFB) pour commander la valeur de la source de courant dans un sens tendant à maintenir la plus constante possible la tension sur les drains des premier et deuxième transistors.

3. Amplificateur à transconductance selon l'une des revendications 1 et 2, **caractérisé en ce que** la résistance est par ailleurs reliée à un potentiel fixe, l'amplificateur à transconductance recevant une tension d'entrée non-différentielle.

4. Amplificateur différentiel à transconductance, **caractérisé en ce qu'**il comporte deux amplificateurs simples à transconductance selon l'une des revendications 1 à 3, les variations de tension à convertir étant appliquées entre les grilles des premiers transistors, l'amplificateur différentiel ayant deux sorties en courant (S, S') fournies à partir du circuit de recopie respectif des deux amplificateurs simples, la résistance étant reliée entre les drains des premiers transistors (MP1, MP'1) des deux amplificateurs simples.

5. Amplificateur différentiel à transconductance selon l'une des revendications 1 à 4, **caractérisé en ce que** le circuit de recopie comporte un quatrième transistor (MN4) de même type que le troisième, le drain de ce transistor fournissant des variations de courant proportionnelles aux variations de tension à échantillonner, l'amplificateur comportant en outre un étage de sortie relié au drain du quatrième transistor, cet étage comportant un cinquième transistor (MP5) d'un type opposé au troisième, dont la source est reliée au drain du premier, dont la grille est polarisée à un potentiel constant (Vref), et dont le drain reçoit les variations de courant (I-di, I+di) qui sont fournies par le quatrième transistor (MN4)

6. Utilisation d'un amplificateur selon l'une des revendications 1 à 5 dans un échantillonneur-bloqueur pour charger, pendant une phase d'échantillonnage périodique de durée fixe, au moins une capacité d'échantillonnage (C_{EI}, C'_{EI}, C_{EQ}, C'_{EQ}) de l'échantillonneur-bloqueur.

## Patentansprüche

1. Transkonduktanzverstärker für die Umwandlung kleiner elektrischer Spannungsschwankungen dv in elektrische Spannungsschwankungen di, der eine Gruppe in Reihe eines ersten und eines zweiten Transistors entgegengesetzten Typs, die durch ihre Drains verbunden sind, aufweist, wobei das Gitter des ersten Transistors (MP1) mit einem Eingang eines in Strom umzuwandelnden Signals verbunden ist, wobei die Source des ersten Transistors mit einer Source konstanten Stroms (I_{B1}) sowie einem Widerstand und dem Drain eines dritten Transistors gleichen Typs wie der erste verbunden ist, wobei die Sourcen des zweiten (MN2) und dritten (MN3) Transistors vereint sind, wobei das Gitter des dritten Transistors mit den Drains des ersten und zweiten Transistors verbunden ist, und der Verstärker ferner eine Stromspiegelschaltung (MN4) des dritten Transistors aufweist, **dadurch gekennzeichnet, dass** das Gitter des zweiten Transistors mit dem Gitter des ersten Transistors verbunden ist.

2. Transkonduktanzverstärker nach Anspruch 1, **dadurch gekennzeichnet, dass** er eine Gegenreaktionsschaltung (CMFB) aufweist, um den Wert der Stromsource in einer Richtung zu steuern, die dazu neigt, die Spannung auf den Drains des ersten und zweiten Transistors so konstant wie möglich zu halten.

3. Transkonduktanzverstärker nach einem der Ansprüche 1 und 2, **dadurch gekennzeichnet, dass** der Widerstand im Übrigen mit einem festen Potential verbunden ist, wobei der Transkonduktanzverstärker eine nicht-differentielle Eingangsspannung empfängt.

4. Differentialtranskonduktanzverstärker, **dadurch gekennzeichnet, dass** er zwei einfache Transkonduktanzverstärker nach einem der Ansprüche 1 bis 3 aufweist, wobei die umzuwandelnden Spannungsschwankungen zwischen den Gittern der ersten Transistoren anliegen, wobei der Differentialverstärker zwei Stromausgänge (S, S') hat, die ab der jeweiligen Stromspiegelschaltung der zwei einfachen Verstärker bedient werden, wobei der Widerstand zwischen den Drains der ersten Transistoren (MP1, MP'1) der zwei einfachen Verstärker verbunden ist.

5. Differentialtranskonduktanzverstärker nach einem der Ansprüche 1 bis 4, **dadurch gekennzeichnet, dass** die Stromspiegelschaltung einen vierten Transistor (MN4) desselben Typs wie der dritte aufweist, wobei der Drain dieses Transistors Stromschwankungen liefert, die zu den abzutastenden Spannungsschwankungen proportional sind, wobei der Verstärker ferner eine Ausgangsetage aufweist, die mit dem Drain des vierten Transistors verbunden ist, wobei diese Etage einen fünften Transistor (MP5) eines Typs aufweist, der dem dritten entgegengesetzt ist, dessen Source mit dem Drain des ersten verbunden ist, dessen Gitter auf ein konstantes Potential (Vref) polarisiert ist und dessen Drain die Stromschwankungen (1-di, 1+di) empfängt, die von dem vierten Transistor (MN4) bereitgestellt werden.

6. Verwendung eines Verstärkers nach einem der Ansprüche 1 bis 5 in einer Abtast- und Halteschaltung, um während einer periodischen Abtastphase fester Dauer mindestens eine Abtastkapazität (C_{EI}, C'_{EI}, C_{EQ}, C'_{EQ}) der Abtast- und Halteschaltung zu laden.

## Claims

1. A transconductance amplifier for the conversion of small electrical voltage variations dv into electrical current variations di, comprising a series assembly of a first and a second transistors of opposite types connected by their drains, the gate of the first transistor (MP1) being connected to an input for signals to be converted into current, the source of the first transistor being connected to a constant current source (I_{B1}) and to a resistor and to the drain of a third transistor of the same type as the first, the sources of the second (MN2) and third (MN3) transistors being combined, the gate of the third transistor being connected to the drains of the first and second transistors, and the amplifier also including a circuit (MN4) for mirroring the current of the third transistor, **characterized in that** the gate of the second transistor is connected to the gate of the first transistor.

2. The transconductance amplifier as claimed in claim 1, **characterized in that** it comprises a feedback circuit (CMFB) for controlling the value of the current source in a direction tending to keep the voltage as constant as possible on the drains of the first and second transistors.

3. The transconductance amplifier as claimed in one of claims 1 and 2, **characterized in that** the resistor is also connected to a fixed potential, the transconductance amplifier receiving a non-differential input voltage.

4. A transconductance differential amplifier, **characterized in that** it comprises two single transconductance amplifiers as claimed in one of claims 1 to 3, the voltage variations to be converted being applied between the gates of the first transistors, the differential amplifier having two current outputs (S, S') supplied from the respective mirroring circuits of the two single amplifiers, the resistor being connected between the drains of the first transistors (MP1, MP1') of the two single amplifiers.

5. The transconductance differential amplifier as claimed in one of claims 1 to 4, **characterized in that** the mirroring circuit comprises a fourth transistor (MN4) of the same type as the third, the drain of this transistor supplying current variations that are proportional to the voltage variations to be sampled, the amplifier also including an output stage connected to the drain of the fourth transistor, this stage including a fifth transistor (MP5) of a type opposite to the third, the source of which is connected to the drain of the first, the gate of which is biased with a constant potential (Vref), and the drain of which receives the current variations (I-di, I+di) that are supplied by the fourth transistor (MN4).

6. A use of an amplifier as claimed in one of claims 1 to 5 in a sample-and-hold device for charging, during a periodic sampling phase of fixed duration, at least one sampling capacitor (C_{EI}, C'_{EI}, C_{EQ}, C'_{EQ}) of the sample-and-hold device.
